# EUROPEAN PATENT SPECIFICATION

(11) **EP 4 075 434 B1**
(45) Date of publication and mention of the grant of the patent: **08.11.2023**
(21) Application number: 22151449.0
(22) Date of filing: 13.01.2022
(51) Int. Cl.: G11C 5/14, G11C 16/30, G06F 1/30

(54) **OVERVOLTAGE DETECTION IN STORAGE DEVICE AND PROVISION OF STATUS INFORMATION**
ERKENNUNG VON ÜBERSPANNUNGEN IN SPEICHERGERÄTEN UND BEREITSTELLUNG VON STATUSINFORMATIONEN
DÉTECTION DE SURTENSION DANS UN DISPOSITIF DE STOCKAGE ET FOURNITURE D'INFORMATIONS D'ÉTAT

(30) Priority: 12.04.2021 KR 20210047304; 28.10.2021 US 202117513549
(43) Date of publication of application: 19.10.2022
(73) Proprietor: Samsung Electronics Co., Ltd., Gyeonggi-do 16677 (KR)
(72) Inventor: KIM, Jihong, 16667 Suwon-si (KR); KIM, Minseok, 16667 Suwon-si (KR); CHOI, Kiyhun, 16667 Suwon-si (KR); KANG, Heeyoub, 16667 Suwon-si (KR); KIM, Jooyoung, 16667 Suwon-si (KR); BANG, Kwangkyu, 16667 Suwon-si (KR)
(74) Representative: Marks & Clerk LLP

(56) References cited:
- US-A- 5 332 993
- US-A1- 2015 149 806
- US-A1- 2017 292 979

## Description

### BACKGROUND

Embodiments of the inventive concept relate to a semiconductor memory, and more particularly, relate to a storage system, a storage device, and an operation method of the storage device.

Semiconductor memories are classified into volatile memory devices, which lose data stored therein when a power supply voltage is turned off, such as a static random access memory (SRAM), a dynamic RAM (DRAM), and a synchronous DRAM (SDRAM), and nonvolatile memory devices, which retain data stored therein even when a power supply voltage is turned off, such as a read only memory (ROM), a programmable ROM (PROM), an electrically programmable ROM (EPROM), an electrically erasable and programmable ROM (EEPROM), a flash memory device, a phase-change RAM (PRAM), a magnetic RAM (MRAM), a resistive RAM (RRAM), and a ferroelectric RAM (FRAM).

A storage device may be a removable storage device for storing data. The storage device may communicate with a host through a universal serial bus (USB) interface. The storage device may be damaged when an over-voltage is consistently applied through the USB interface.

US-A-20150149806 discloses a method which comprises, in accordance with a determination that a power supply voltage is higher than an over-voltage threshold, signaling a power fail operation to a plurality of controllers on the storage device; transferring data held in volatile memory to non-volatile memory; and removing power from the plurality of controllers on the storage device.

US-A-5332993 discloses a CPU in a power source controller generates various error status data, that correspond to various kinds of failure conditions, based on detection signals supplied from a variety of failure detection circuits provided at a power source circuit. The CPU controls an LED in a blinker based on the error status data to light up and extinguish the LED in an orderly fashion which is fixed by the generated data, so that the blinker blinks variously in correspondence with various kinds of power failure conditions. Thus, a various kinds of power failure conditions can be indicated by difference in blinking operation of the blinker.

US-A-20170292979 discloses an overvoltage detection circuit coupled to an external power supply via a voltage supply line and comprising a transistor comprising first terminal coupled to the voltage supply line, second terminal coupled to the first terminal via a resistor, the second terminal coupled to a parasitic capacitor, the transistor configured to receive an overvoltage spike from the external power supply on the first terminal, and provide an output voltage on third terminal of the transistor to indicate detection of the overvoltage spike when it has a duration less than a time constant based on the resistor and the parasitic capacitor and amplitude that exceeds a threshold voltage of the transistor. The overvoltage detection circuit further comprises a monitor circuit configured to receive the output voltage from the transistor and provide a digital signal providing a notification of the detected overvoltage spike from the external power supply on the voltage supply line.

### SUMMARY

Embodiments of the present disclosure provide a storage system capable of notifying a user or a host that an over-voltage is received, a storage device, and an operation method of the storage device.

The invention provides a storage device according to claim 1.

The invention also provides a method as claimed in claim 11.

At least some of the above and other features of the invention are set out in the claims.

### BRIEF DESCRIPTION OF THE FIGURES

The above and other objects and features of the present disclosure will become apparent by describing in detail embodiments thereof with reference to the accompanying drawings.
FIG. 1 is a block diagram illustrating a storage system according to an embodiment of the present disclosure.
FIG. 2 is a block diagram illustrating a storage device of FIG. 1 according to example embodiments.
FIG. 3 is a block diagram illustrating a storage controller of FIG. 1 according to example embodiments.
FIG. 4 is a flowchart illustrating an operation of a storage device of FIG. 1 according to example embodiments.
FIG. 5 is a flowchart illustrating operation S110 of FIG. 4 in detail according to example embodiments.
FIG. 6 is a flowchart illustrating operation S140 of FIG. 4 in detail according to example embodiments.
FIG. 7 is a block diagram illustrating a storage system according to an embodiment of the present disclosure.
FIG. 8 is a flowchart illustrating operation S110 of FIG. 4 in more detail according to example embodiments.
FIG. 9 is a flowchart illustrating operation S120 of FIG. 4 in detail according to example embodiments.
FIG. 10 is a block diagram illustrating a storage device of FIG. 1 according to example embodiments.
FIG. 11 is a block diagram illustrating a storage device of FIG. 1 according to example embodiments.
FIG. 12 is a block diagram illustrating a storage device of FIG. 1 according to example embodiments.
FIG. 13 is a block diagram illustrating a storage device of FIG. 1 according to example embodiments.
FIG. 14 is a block diagram illustrating a storage device of FIG. 1 according to example embodiments.
FIG. 15 is a block diagram illustrating a storage device of FIG. 1 according to example embodiments.

### DETAILED DESCRIPTION

Below, embodiments of the present disclosure will be described in detail and clearly to such an extent that one skilled in the art easily carries out the present disclosure.

Components described in the specification by using the terms "part", "unit", "module", "engine", etc. and function blocks illustrated in drawings may be implemented with software, hardware, or a combination thereof. For example, the software may be a machine code, firmware, an embedded code, and application software. For example, the hardware may include an electrical circuit, an electronic circuit, a processor, a computer, an integrated circuit, integrated circuit cores, a pressure sensor, an inertial sensor, a microelectromechanical system (MEMS), a passive element, or a combination thereof.

Also, unless differently defined, all terms used herein, which include technical terminologies or scientific terminologies, have the same meaning as that understood by a person skilled in the art to which the inventive concept belongs. Terms defined in a generally used dictionary are to be interpreted to have meanings equal to the contextual meanings in a relevant technical field, and are not interpreted to have ideal or excessively formal meanings unless clearly defined in the specification.

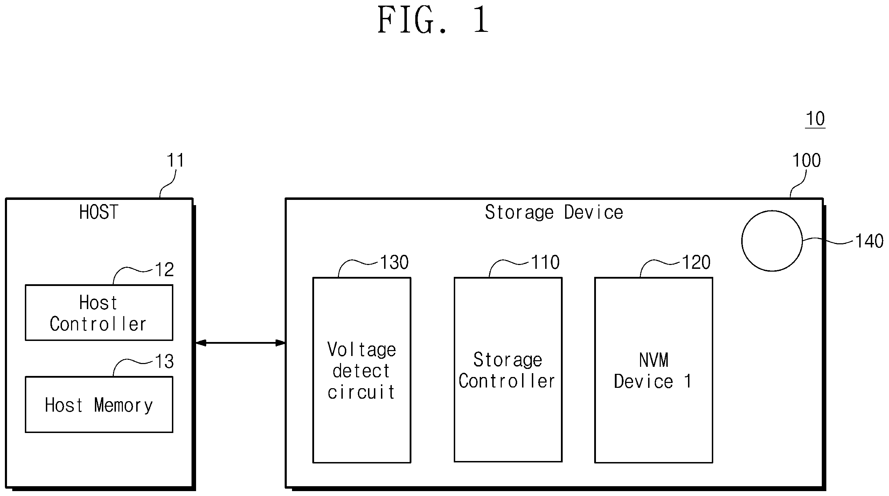

FIG. 1 is a block diagram illustrating a storage system according to an embodiment of the present disclosure. Referring to FIG. 1, a storage system 10 may include a host 11 and a storage device 100. In an embodiment, the storage system 10 may be one of information processing devices, which are configured to process a variety of information and to store the processed information, such as a personal computer (PC), a laptop, a server, a workstation, a smartphone, a tablet PC, a digital camera, and a black box.

The host 11 may control overall operations of the storage system 10. For example, the host 11 may send, to the storage device 100, a request (RQ) for storing data "DATA" in the storage device 100 or reading the data "DATA" stored in the storage device 100. In an embodiment, the host 11 may be a processor core, which is configured to control the storage system 10, such as a central processing unit (CPU) or an application processor, or may be a computing node connected through a network.

In an embodiment, the host 11 may include a host controller 12 and a host memory 13. The host controller 12 may be a device configured to control overall operations of the host 11 or to allow the host 11 to control the storage device 100. The host memory 13 may be a buffer memory, a cache memory, or a working memory that is used in the host 11.

The storage device 100 may operate under control of the host 11. The storage device 100 may include a storage controller 110, a first nonvolatile memory device 120, a voltage detect circuit 130, and a status display device 140. Under control of the host 11, the storage controller 110 may store data to the first nonvolatile memory device 120 or may read data stored in the first nonvolatile memory device 120. In an embodiment, the storage controller 110 may perform various management operations for efficiently using the first nonvolatile memory device 120. In an embodiment, the storage controller 110 may be a nonvolatile memory express (NVMe) controller that is based on an NVMe interface.

Under control of the storage controller 110, the first nonvolatile memory device 120 may store data or may output the stored data. In an embodiment, the first nonvolatile memory device 120 may be a NAND flash memory. However, the present disclosure is not limited thereto. For example, the first nonvolatile memory device 120 may include at least one of nonvolatile memory devices such as a read only memory (ROM), a programmable ROM (PROM), an electrically programmable ROM (EPROM), an electrically erasable and programmable ROM (EEPROM), a flash memory device, a phase-change RAM (PRAM), a magnetic RAM (MRAM), a resistive RAM (RRAM), and a ferroelectric RAM (FRAM).

The voltage detect circuit 130 may detect whether a voltage provided from the host 11 through a connector (not illustrated) is an over-voltage. For example, the voltage detect circuit 130 may detect whether an input voltage provided to the storage device 100 from the host 11 exceeds a reference voltage. When the input voltage exceeds the reference voltage (i.e., when an over-voltage is applied from the host 11 to the storage device 100), the voltage detect circuit 130 may provide an over-voltage detect signal to the storage controller 110.

In an embodiment, a voltage that is necessary for an operation of the storage device 100 may be provided through a connector (not illustrated). When a voltage being out of an allowable range of components of the storage device 100 is provided through the connector, the storage device 100 may fail to provide an intended operation. When an excessively high voltage is provided to the storage device 100, the storage device 100 may be damaged. For example, when a voltage exceeding a breakdown voltage is provided to the storage device 100, the storage device 100 may be damaged.

For example, an excessively high voltage (e.g., a surge voltage) may be applied to the storage device 100 through the connector. When the storage device 100 is damaged, the storage device 100 may abnormally operate, and data stored in the storage device 100 may be damaged. Accordingly, example embodiments of the present disclosure may protect the storage device 100 against an excessively high voltage such that the storage device 100 may not be damaged. In the present disclosure, an excessively high voltage being out of an allowable range of the storage device 100 may be referred to as an "over-voltage".

In an embodiment, the storage controller 110 may receive the over-voltage detect signal from the voltage detect circuit 130. In response to the over-voltage detect signal, the storage controller 110 may allow the status display device 140 to display an input voltage status (or an over-voltage input status or an over-voltage detect status). For example, the storage controller 110 may output a blink enable signal to the status display device 140 such that the over-voltage input status is displayed to the user.

In an embodiment, the storage controller 110 may store status information of the storage controller 110 in a memory in response to the over-voltage detect signal. The status information may include information about integrated circuits included in the storage device 100. The status information may indicate current status information capable of being used for fault analysis. For example, the status information may include first status information of a power management circuit included in the storage device 100. Alternatively, the status information may include second status information of a temperature sensor included in the storage device 100.

In an embodiment, when the input voltage exceeds the reference voltage, the storage controller 110 may notify an input voltage status to the host 11. The storage controller 110 may notify the over-voltage input status to the host 11. For example, the storage controller 110 may notify the host 11 whether an over-voltage is received, through an asynchronous event request.

In an embodiment, the storage controller 110 may send status information to the host 11. For example, when the input voltage exceeds the reference voltage, the storage controller 110 may update a log with the status information. The storage controller 110 may send an asynchronous event request completion to the host 11. The host 11 may send a "Get Log Page" command to the storage controller 110 in response to the asynchronous event request completion. The storage controller 110 may receive the "Get Log Page" command. The storage controller 110 may send, to the host 11, log data including the status information and a "Get Log Page" completion in response to the "Get Log Page" command.

The status display device 140 may be implemented to display an input voltage status of the storage device 100. For example, the status display device 140 may be implemented to notify the user a status of an input voltage provided from the host 11 through the connector.

In an embodiment, when the input voltage exceeds the reference voltage, the status display device 140 may display an over-voltage detect status under control of the storage controller 110. The user may check a connecting status of the host 11 and the storage device 100 through the status display device 140 and may perform a work such as disconnection of the host 11 from the storage device 100.

As described above, according to an embodiment of the present disclosure, when an over-voltage is received from the host 11, the storage device 100 may display an over-voltage detect status to the user through the status display device 140. The storage device 100 may store status information capable of being used for fault analysis later, in the memory. The storage device 100 may notify the over-voltage detect status to the host 11 and provide the status information to the host 11. A configuration according to an embodiment of the present disclosure will be described in more detail with reference to the following drawings.

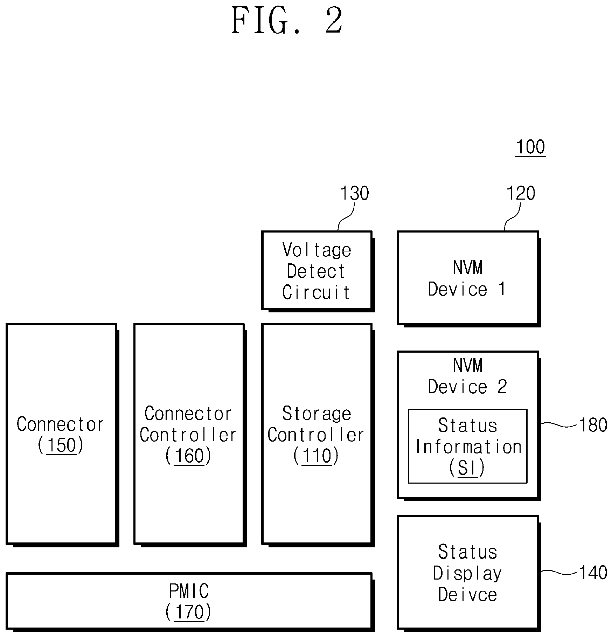

FIG. 2 is a block diagram illustrating a storage device of FIG. 1 according to example embodiments. Referring to FIGS. 1 and 2, the storage device 100 may include the storage controller 110, the first nonvolatile memory device 120, the voltage detect circuit 130, the status display device 140, a connector 150, a connector controller 160, a power management integrated circuit (PMIC) 170, and a second nonvolatile memory device 180.

The storage controller 110 may be configured to process various requests from the host 11. For example, depending on a request from the host 11, the storage controller 110 may store data in the first nonvolatile memory device 120 or may read data stored therein. In an embodiment, the storage controller 110 may be a nonvolatile memory express (NVMe) controller that is based on an NVMe interface.

The storage controller 110 may receive the over-voltage detect signal from the voltage detect circuit 130. For example, the storage controller 110 may recognize whether an over-voltage is received, through the over-voltage detect signal input through a general purpose input/output (GPIO) pin. The storage controller 110 may determine whether the input voltage exceeds the reference voltage, based on a logic level of the over-voltage detect signal. The storage controller 110 may provide an input voltage status, which indicates whether the input voltage exceeds the reference voltage, to the user through the status display device 140. The storage controller 110 may notify the input voltage status to the host 11 through the asynchronous event request completion.

Under control of the storage controller 110, the first nonvolatile memory device 120 may store data or may output the stored data. In an embodiment, the first nonvolatile memory device 120 may be a NAND flash memory.

The voltage detect circuit 130 may detect an over-voltage on a pin included in the connector 150. When an over-voltage is detected, the voltage detect circuit 130 may output the over-voltage detect signal to the storage controller 110. For example, the over-voltage detect signal may be input to the storage controller 110 through the GPIO pin.

The status display device 140 may display the input voltage status under control of the storage controller 110. In an embodiment, the status display device 140 may include a light-emitting diode (LED) for displaying the input voltage status. For example, a blinking operation of the light-emitting diode may display that the input voltage exceeding the reference voltage is received. For example, the blinking operation of the light-emitting diode may display that an over-voltage is applied from the host 11.

In an embodiment, the status display device 140 may communicate with the storage controller 110 through at least one of I²C, system management bus (SMBus), universal asynchronous receiver transmitter (UART), serial peripheral interface (SPI), and high-speed inter-chip (HSIC).

In an embodiment, the status display device 140 according to an embodiment of the present disclosure may output an alarm by using an alarm device. Alternatively, the status display device 140 may display the input voltage status in the form of a message box or a graph, by using a display device (e.g., a liquid crystal display (LCD)). The storage device 100 may exchange a signal with the host 11 through the connector 150. The storage device 100 may receive a power from the host 11 through the connector 150. In an embodiment, the connector 150 may be a universal serial bus (USB) port. The storage device 100 may communicate with the host 11 in compliance with a USB interface standard. In an embodiment, the connector 150 may be a thunderbolt port. The storage device 100 may communicate with the host 11 in compliance with a thunderbolt interface standard.

In an embodiment, the storage device 100 may be a removable storage device or a portable storage device for storing data. For example, the storage device 100 may be a removable solid state drive (SSD) or a portable SSD. Meanwhile, the present disclosure is not limited to the removable (or portable) SSD. For example, it should be understood that the storage device 100 is implemented by using various kinds of storage devices.

For example, it is assumed that the connector 150 is a USB port. The connector 150 may be connected with a USB cable or a USB plug being a part of a USB entity, for the purpose of the connection with a host USB entity. The connector 150 may include a plurality of exposed pins. Signals may be transmitted/received through the plurality of exposed pins, or a power may be transferred through the plurality of exposed pins. For example, the connector 150 may include pins for transferring a pair of transmit signals TX+ and TX-, a pair of receive signals RX+ and RX-, channel configuration signals CC1 and CC2, a VBUS voltage V_BUS, and a ground voltage. In an embodiment, the connector 150 may have a pin configuration according to the USB Type-C, but the present disclosure is not limited thereto.

When a conductive foreign material is introduced into the connector 150, with the USB plug not connected with the connector 150, or when a short circuit occurs at the USB cable connected with the connector 150, two or more of the pins included in the connector 150 may be electrically connected. The pins that are inappropriately electrically connected may cause a leakage current, and the leakage current may cause the damage of the storage device 100 or the host 11 as well as the failure of communication through the USB interface. In particular, in the case where the storage device 100 is a removable (or portable) storage device, a conductive material such as water or metal may be easily introduced into the connector 150, thereby causing the excessive power consumption or damage of the storage device 100. For example, the USB power delivery (PD) may define a delivery of a high power such as 20 V and 5 A through a VBUS pin, and when the VBUS pin and any other pin are short-circuited, the high voltage and current of the VBUS pin may be applied to the short-circuited pin. To protect the storage device 100 from the high voltage and current, the storage device 100 may include the voltage detect circuit 130.

The connector controller 160 may exchange signals with the connector 150. The connector controller 160 may exchange signals according to a first interface with the connector 150. For example, the connector controller 160 may exchange signals according to the USB interface standard or the thunderbolt interface standard with the connector 150. For example, the first interface may be one of the USB interface standard or the thunderbolt interface standard.

The connector controller 160 may communicate with the storage controller 110 through a second interface. For example, the connector controller 160 may communicate with the storage controller 110 in compliance with a PCIe (Peripheral Component Interconnection express) interface standard. For example, the second interface may be a PCIe interface.

In an embodiment, the connector controller 160 may convert a signal according to the first interface (or a first interface-based signal) into a signal according to the second interface (or a second interface-based signal). For example, the connector controller 160 may convert a signal complying with the USB interface standard into a signal complying with the PCIe interface standard. Alternatively, the connector controller 160 may convert a signal complying with the thunderbolt interface standard into a signal complying with the PCIe interface standard, for example.

In an embodiment, the connector controller 160 may convert a second interface-based signal into a first interface-based signal. For example, the connector controller 160 may convert a signal complying with the PCIe interface standard into a signal complying with the USB interface standard. Alternatively, the connector controller 160 may convert a signal complying with the PCIe interface standard into a signal complying with the thunderbolt interface standard.

As described above, the connector controller 160 may convert a signal received from the host 11 through the first interface into a signal complying with the standard of the second interface so as to be output to the storage controller 110. Alternatively, the connector controller 160 may convert a signal received from the storage controller 110 through the second interface into a signal complying with the standard of the first interface so as to be output to the connector 150.

The power management integrated circuit 170 may provide a power necessary for the storage device 100 to operate, based on a power provided from the host 11 through the connector 150. For example, the power management integrated circuit 170 may receive a power (or an input voltage) through the VBUS pin of the connector 150. The power management integrated circuit 170 may supply a power necessary for each of the storage controller 110, the first nonvolatile memory device 120, the status display device 140, the connector controller 160, and the second nonvolatile memory device 180 to operate.

In an embodiment, the power management integrated circuit 170 may provide first status information depending on a request from the storage controller 110. The first status information may provide a useful means for fault analysis or debugging and may indicate information necessary to detect and correct an abnormal operation of the power management integrated circuit 170. The first status information may include pieces of information stored in a plurality of registers included in the power management integrated circuit 170. The first status information may include information about a voltage or current used within a logic block included in the power management integrated circuit 170 or information about a voltage or current of a specific node within the logic block. The first status information may include information about a general-purpose interrupt signal.

For example, the first status information may include information about levels of voltages that are generated based on the input voltage provided from the host 11 and are respectively to be provided to components of the storage device 100. The power management integrated circuit 170 may provide a first operating voltage to the connector controller 160, may provide a second operating voltage to the storage controller 110, and may provide a third operating voltage to the first nonvolatile memory device 120. Levels of the first operating voltage, the second operating voltage, and the third operating voltage may be different. The first status information may include information about the levels of the first to third operating voltages.

The power management integrated circuit 170 may operate in a normal mode or a low-power mode. For example, an operating mode of the power management integrated circuit 170 may include the normal mode and the low-power mode. The first status information may include information about an operating mode that is currently executed. The power management integrated circuit 170 may generate a power status signal PWR_GOOD. The first status information may include information about the power status signal PWR_GOOD. The power management integrated circuit 170 may detect an over-current or over-voltage. The first status information may include information about an over-current or over-voltage.

The second nonvolatile memory device 180 may be configured to store status information SI. The second nonvolatile memory device 180 may operate under control of the storage controller 110. For example, the status information SI may indicate information that is used in fault analysis. In detail, the status information SI may include status information of an integrated circuit included in the storage device 100.

In an embodiment, the second nonvolatile memory device 180 may include at least one of a ROM, a PROM, an EPROM, an electronic fuse (eFuse), an EEPROM, a mask ROM, a serial PROM, a flash memory, a one-time programmable (OTP) memory, and a serial flash memory.

In an embodiment, the second nonvolatile memory device 180 may communicate with the storage controller 110 through at least one of I²C, SMBus, UART, SPI, and HSIC.

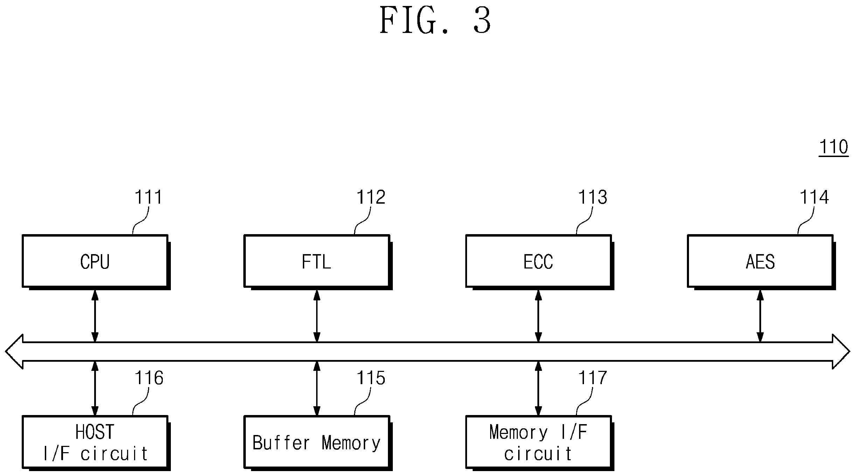

FIG. 3 is a block diagram illustrating a storage controller of FIG. 1 according to example embodiments. Referring to FIGS. 1 and 3, the storage controller 110 may include a central processing unit (CPU) 111, a flash translation layer (FTL) 112, an error correction code (ECC) engine 113, an advanced encryption standard (AES) engine 114, a buffer memory 115, a host interface circuit 116, and a memory interface circuit 117.

The CPU 111 may perform overall operations of the storage controller 110. The FTL 112 may perform various operations for efficiently using the first nonvolatile memory device 120. For example, the host 11 may manage a storage space of the storage device 100 by using logical addresses. The FTL 112 may be configured to manage address mapping between a logical address from the host 11 and a physical address of the storage device 100. The FTL 112 may perform a wear-leveling operation to prevent excessive degradation of a specific memory block among memory blocks of the first nonvolatile memory device 120. The lifetime of the first nonvolatile memory device 120 may be improved by the wear-leveling operation of the FTL 112. The FTL 112 may perform a garbage collection operation on the first nonvolatile memory device 120 to secure a free memory block.

In an embodiment, the FTL 112 may be implemented in the form of hardware or software. In the case where the FTL 112 is implemented in the form of software, a program code or information associated with the FTL 112 may be stored in the buffer memory 115 and may be executed by the CPU 111. In the case where the FTL 112 is implemented in the form of hardware, a hardware accelerator configured to perform an operation of the FTL 112 may be separately provided.

The ECC engine 113 may perform error detection and correction on data read from the first nonvolatile memory device 120. For example, the ECC engine 113 may generate an error correction code (or a parity bit(s)) for data to be written in the first nonvolatile memory device 120. The error correction code (or parity bit(s)) thus generated may be stored in the first nonvolatile memory device 120 together with the data to be written. Afterwards, when the written data are read from the first nonvolatile memory device 120, the ECC engine 113 may detect and correct an error of the read data based on the read data and the corresponding error correction code (or the corresponding parity bit(s)).

The AES engine 114 may perform an encryption operation on data received from the host 11 and may perform a decryption operation on data received from the first nonvolatile memory device 120. In an embodiment, the encryption operation and the decryption operation may be performed based on a symmetric-key algorithm.

The buffer memory 115 may be a write buffer or a read buffer configured to temporarily store data input to the storage controller 110. Alternatively, the buffer memory 115 may be configured to store a variety of information necessary for the storage controller 110 to operate. For example, the buffer memory 115 may store a mapping table that is managed by the FTL 112. Alternatively, the buffer memory 115 may store software, firmware, or information that is associated with the FTL 112.

In an embodiment, the buffer memory 115 may be an SRAM, but the present disclosure is not limited thereto. For example, the buffer memory 115 may be implemented with various kinds of memory devices such as a DRAM, an MRAM, and a PRAM. For brevity of drawing and for convenience of description, an example in the buffer memory 115 is included in the storage controller 110 is illustrated in FIG. 3, but the present disclosure is not limited thereto. The buffer memory 115 may be placed outside the storage controller 110, and the storage controller 110 may communicate with the buffer memory 115 through a separate communication channel or interface.

The host interface circuit 116 may communicate with the host 11 in compliance with the given interface protocol. In an embodiment, the given interface protocol may include at least one of protocols for various interfaces such as an ATA (Advanced Technology Attachment) interface, an SATA (Serial ATA) interface, an e-SATA (external SATA) interface, an SCSI (Small Computer Small Interface) interface, an SAS (Serial Attached SCSI) interface, a PCI (Peripheral Component Interconnection) interface, a PCIe (PCI express) interface, an NVMe (NVM express) interface, an IEEE 1394 interface, an USB (Universal Serial Bus) interface, an SD (Secure Digital) card interface, an MMC (Multi-Media Card) interface, an eMMC (embedded Multi-Media Card) interface, an UFS (Universal Flash Storage) interface, an eUFS (embedded Universal Flash Storage) interface, a CF (Compact Flash) card interface, or a network interface. The host interface circuit 116 may receive a signal, which is based on the given interface protocol, from the host 11 and may operate based on the received signal. Alternatively, the host interface circuit 116 may send a signal, which is based on the given interface protocol, to the host 11.

The memory interface circuit 117 may communicate with the first nonvolatile memory device 120 in compliance with the given interface protocol. In an embodiment, the given interface protocol may include at least one of protocols for various interfaces such as a toggle interface and an open NAND flash interface (ONFI). In an embodiment, the memory interface circuit 117 may communicate with the first nonvolatile memory device 120 based on the toggle interface. In this case, the memory interface circuit 117 may communicate with the first nonvolatile memory device 120 through a plurality of channels CHs. In an embodiment, each of the plurality of channels CHs may include a plurality of signal lines configured to transfer various control signals (e.g., /CE, CLE, ALE, /WE, /RE, and R/B), data signals DQ, and a data strobe signal DQS.

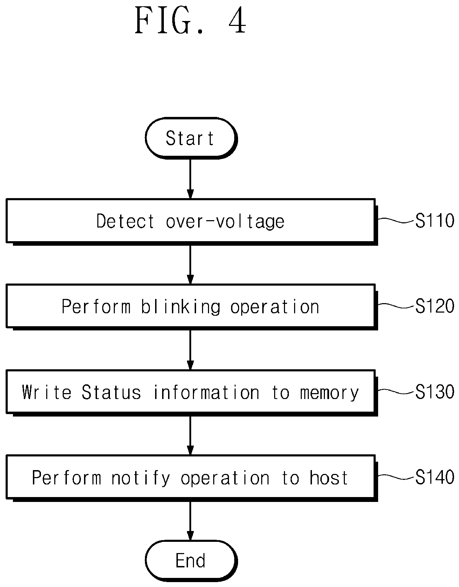

FIG. 4 is a flowchart illustrating an operation of a storage device of FIG. 1 according to example embodiments. Referring to FIGS. 1, 2, and 4, in operation S110, the storage device 100 may detect an over-voltage. For example, the voltage detect circuit 130 may detect whether an over-voltage is received from the host 11. The voltage detect circuit 130 may determine whether an input voltage provided from the host 11 through the connector 150 exceeds the reference voltage. The voltage detect circuit 130 may determine whether the input voltage is greater than the reference voltage, by comparing the input voltage with the reference voltage.

In operation S120, the storage device 100 may perform a blinking operation. For example, when the input voltage exceeds the reference voltage, the status display device 140 may perform the blinking operation. The status display device 140 may blink the light-emitting diode periodically. The status display device 140 may notify the user that the over-voltage is input to the storage device 100, by using the blinking operation of the light-emitting diode.

In operation S130, the storage device 100 may store status information in a memory. For example, the storage controller 110 may store the status information SI in the second nonvolatile memory device 180.

In an embodiment, the storage controller 110 may request first status information to the power management integrated circuit 170. The storage controller 110 may receive the first status information from the power management integrated circuit 170. The storage controller 110 may write the first status information provided from the power management integrated circuit 170 in the second nonvolatile memory device 180.

In operation S140, the storage device 100 may perform a notify operation to the host 11. The storage device 100 may send an over-voltage input status and status information to the host 11. For example, through the asynchronous event request completion, the storage controller 110 may provide notification that the input voltage exceeds the reference voltage. The storage controller 110 may send the status information to the host 11 through the "Get Log Page" completion.

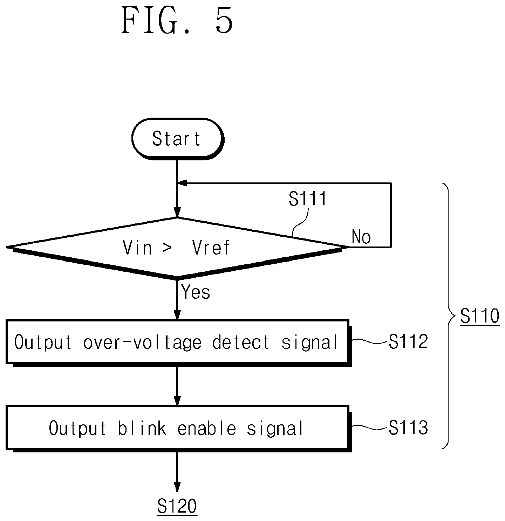

FIG. 5 is a flowchart illustrating operation S110 of FIG. 4 in detail according to example embodiments. Referring to FIGS. 1, 2, 4, and 5, in operation S111, the storage device 100 may determine whether an input voltage Vin exceeds a reference voltage Vref. For example, the voltage detect circuit 130 may compare the input voltage Vin provided from the host 11 with the reference voltage Vref. When the input voltage Vin exceeds the reference voltage Vref, the voltage detect circuit 130 may detect that an over-voltage is detected. The reference voltage Vref may indicate a voltage level determined in advance. The reference voltage Vref may be determined based on a voltage level that the storage device 100 is capable of allowing.

When the input voltage Vin exceeds the reference voltage Vref, the storage device 100 may perform operation S112. When the input voltage Vin is smaller than or equal to the reference voltage Vref, the storage device 100 may continuously perform operation S111.

For example, the voltage detect circuit 130 may output the over-voltage detect signal. For example, when the input voltage Vin exceeds the reference voltage Vref (i.e., when the input voltage Vin is determined as an over-voltage), the voltage detect circuit 130 may output the over-voltage detect signal to the storage controller 110. The over-voltage detect signal may be a signal for notifying the storage controller 110 that an over-voltage is received.

In an embodiment, the voltage detect circuit 130 may set the over-voltage detect signal to logical low or logical high. The logical high may indicate a state where an input voltage is greater than a reference voltage, and the logical low may indicate a state where an input voltage is smaller than a reference voltage.

In an embodiment, the voltage detect circuit 130 may set the over-voltage detect signal to either logical low or logical high when the input voltage is equal to the reference voltage.

In operation S113, the storage controller 110 may output the blink enable signal to the status display device 140. The storage controller 110 may output the blink enable signal to the status display device 140 in response to the over-voltage detect signal. For example, the storage controller 110 may receive the over-voltage detect signal of logical high. The storage controller 110 may output the blink enable signal to the status display device 140 in response to the over-voltage detect signal of logical high. The blink enable signal may indicate a signal allowing the status display device 140 to perform the blinking operation.

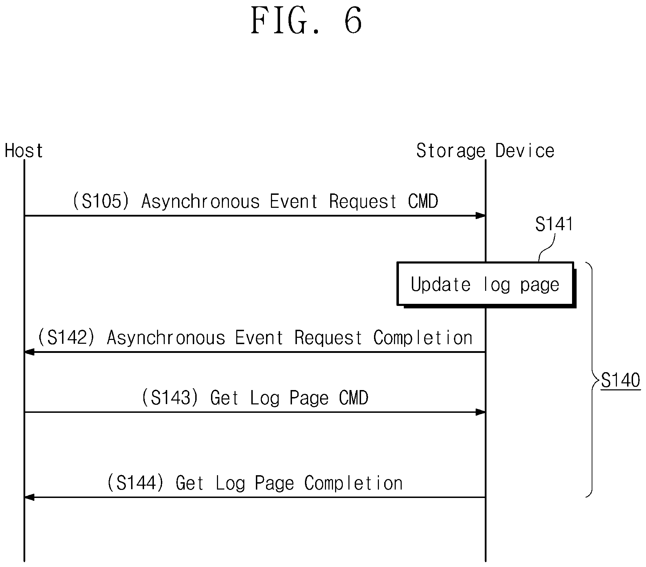

FIG. 6 is a flowchart illustrating operation S140 of FIG. 4 in detail according to example embodiments. Referring to FIGS. 1, 2, 4, and 6, in operation S105, the host 11 may send an asynchronous event request command to the storage device 100. The asynchronous event request command may be a timeout-free command. In the case where the storage device 100 receives the asynchronous event request command, the storage device 100 may not send a completion immediately, but the storage device 100 may send a completion when an event occurs.

In an embodiment, operation S105 may be performed before operation S110. Because the asynchronous event request command is a timeout-free command, the storage device 100 may receive the asynchronous event request command before detecting whether an input voltage exceeds a reference voltage.

When an over-voltage is detected (i.e., when an event occurs), the storage device 100 may display an input voltage status to the user through the status display device 140 and may store the status information SI in the second nonvolatile memory device 180.

In operation S141, the storage device 100 may update a log with the status information SI. For example, the storage device 100 may update the log with the status information SI including first status information of the power management integrated circuit 170. Returning to FIG. 3, the log may be stored in the buffer memory 115 of the storage controller 110 and/or the first nonvolatile memory device 120.

In operation S142, the storage device 100 may send an asynchronous event request completion for the purpose of notifying the host 11 that an event occurs. For example, the event may indicate a state where an input voltage exceeds a reference voltage.

In an embodiment, the asynchronous event request completion may include a log identifier and event type information. The storage device 100 may allow the host 11 to read the updated log through the asynchronous event request completion. For example, the log identifier and the event type information may be newly defined with regard to detecting an over-voltage.

In an embodiment, the storage device 100 may send the asynchronous event request completion including the status information SI to the host 11. In this case, a "Get Log Page" procedure to be described later may not be performed.

In operation S143, the host 11 may send a "Get Log Page" command to the storage device 100. The "Get Log Page" command may include a log identifier, a log data size, a host memory address where log data read from the storage device 100 is to be stored, etc.

In operation S144, the storage device 100 may send a "Get Log Page" completion. After the log data are written at the host memory address included in the "Get Log Page" command, the "Get Log Page" completion may be sent. For example, the log data may be written in the host memory 13 corresponding to the host memory address.

As described above, the storage device 100 may notify an abnormal power status to the host 11. For example, the storage device 100 may notify the host 11 that an over-voltage is being received. As such, the host 11 may recognize the abnormal power status of the storage device 100 and may be provided with the status information SI of the storage device 100.

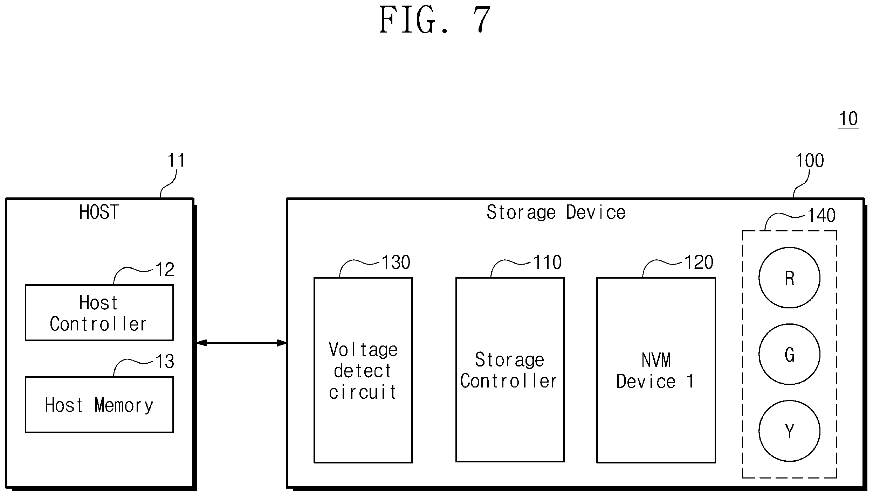

FIG. 7 is a block diagram illustrating a storage system according to an embodiment of the present disclosure. Referring to FIG. 7, the storage system 10 may include the host 11 and the storage device 100. The host 11 may include the host controller 12 and the host memory 13. The storage device 100 may include the storage controller 110, the first nonvolatile memory device 120, the voltage detect circuit 130, and the status display device 140. For convenience of description, additional description associated with the components described above will be omitted to avoid redundancy.

In an embodiment, the status display device 140 may include a plurality of light-emitting diodes (e.g., a green light-emitting diode "G", a red light-emitting diode "R", and a yellow light-emitting diode "Y") for displaying an input voltage status. The green light-emitting diode "G" may display a state where an input voltage is smaller than or equal to a first reference voltage, the red light-emitting diode "R" may display a state where the input voltage exceeds a second reference voltage, and the yellow light-emitting diode "Y" may display a state where the input voltage exceeds the first reference voltage and is smaller than or equal to the second reference voltage. An example where the status display device 140 is composed of three light-emitting diodes "G", "R", and "Y" is illustrated in FIG. 7, but the present disclosure is not limited thereto. For example, the number of light-emitting diodes of the status display device 140 may increase or decrease depending on a way to implement. In other words there may be plural indicators indicating various status levels of the input voltage.

The status display device 140 of FIG. 1 may include one light-emitting diode and may notify the user that an over-voltage is detected, through a blinking operation of the light-emitting diode. The status display device 140 of FIG. 7 may include three light-emitting diodes and may display various statuses of an input voltage through a plurality of light-emitting diodes. For example, the status display device 140 of FIG. 7 may individually display a danger status where the input voltage exceeds the second reference voltage, a caution status where the input voltage exceeds the first reference voltage and is smaller than or equal to the second reference voltage, and a normal status where the input voltage is smaller than or equal to the first reference voltage.

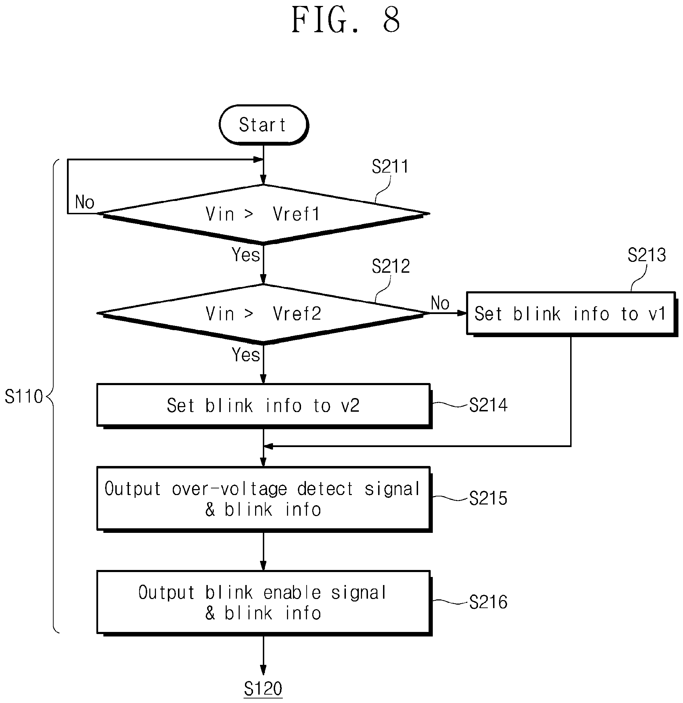

FIG. 8 is a flowchart illustrating operation S110 of FIG. 4 in more detail according to example embodiments. Referring to FIGS. 2, 4, 7, and 8, in operation S211, the voltage detect circuit 130 may determine whether the input voltage Vin exceeds a first reference voltage Vref1. For example, the voltage detect circuit 130 may compare the input voltage Vin provided from the host 11 with the first reference voltage Vref1. When the input voltage Vin exceeds the first reference voltage Vref1, the voltage detect circuit 130 may perform operation S212. When the input voltage Vin is smaller than or equal to the first reference voltage Vref1, the storage device 100 may continuously perform operation S211.

In operation S212, the voltage detect circuit 130 may determine whether the input voltage Vin exceeds a second reference voltage Vref2. Here, a level of the second reference voltage Vref2 may be higher than a level of the first reference voltage Vref1. For example, the voltage detect circuit 130 may compare the input voltage Vin with the second reference voltage Vref2. When the input voltage Vin exceeds the second reference voltage Vref2, the voltage detect circuit 130 may perform operation S214. When the input voltage Vin is smaller than or equal to the second reference voltage Vref2, the voltage detect circuit 130 may perform operation S213.

For example, the first and second reference voltages Vref1 and Vref2 may indicate voltage levels determined in advance. The first and second reference voltages Vref1 and Vref2 may be determined based on a voltage level that the storage device 100 is capable of allowing.

In operation S213, the voltage detect circuit 130 may set blink information to a first value V1. For example, the blink information may be initialized to a default value indicating a normal status. When the input voltage Vin exceeds the first reference voltage Vref1 and is smaller than or equal to the second reference voltage Vref2, the voltage detect circuit 130 may set the blink information to the first value V1 indicating the caution status.

In operation S214, the voltage detect circuit 130 may set the blink information to a second value V2. For example, when the input voltage Vin exceeds the second reference voltage Vref2, the voltage detect circuit 130 may set the blink information to the second value V2 indicating the danger status.

In operation S215, the voltage detect circuit 130 may output the over-voltage detect signal and the blink information to the storage controller 110. The over-voltage detect signal may be output when the input voltage Vin exceeds the first reference voltage Vref1. The over-voltage detect signal may be a signal for notifying the storage controller 110 that an over-voltage is received.

In an embodiment, the voltage detect circuit 130 may set the over-voltage detect signal to logical low or logical high. The logical high may indicate a state where the input voltage Vin is greater than the first reference voltage Vref1, and the logical low may indicate a state where the input voltage Vin is smaller than the first reference voltage Vref1.

In an embodiment, the voltage detect circuit 130 may set the over-voltage detect signal to either logical low or logical high when the input voltage is equal to the first reference voltage Vref1.

In an embodiment, the blink information may indicate whether the input voltage Vin exceeds the second reference voltage Vref2. For example, the case where the blink information includes the first value V1 may indicate a state where the input voltage Vin exceeds the first reference voltage Vref1 and is smaller than or equal to the second reference voltage Vref2. The case where the blink information includes the second value V2 may indicate a state where the input voltage Vin exceeds the second reference voltage Vref2.

In operation S216, the storage controller 110 may output the blink enable signal and the blink information to the status display device 140. The storage controller 110 may output the blink enable signal to the status display device 140 in response to the over-voltage detect signal and may output the received blink information. For example, the storage controller 110 may receive the over-voltage detect signal of logical high and the blink information. The storage controller 110 may output the blink enable signal and the blink information to the status display device 140 in response to the over-voltage detect signal of logical high. After operation S216, the storage device 100 may perform operation S120.

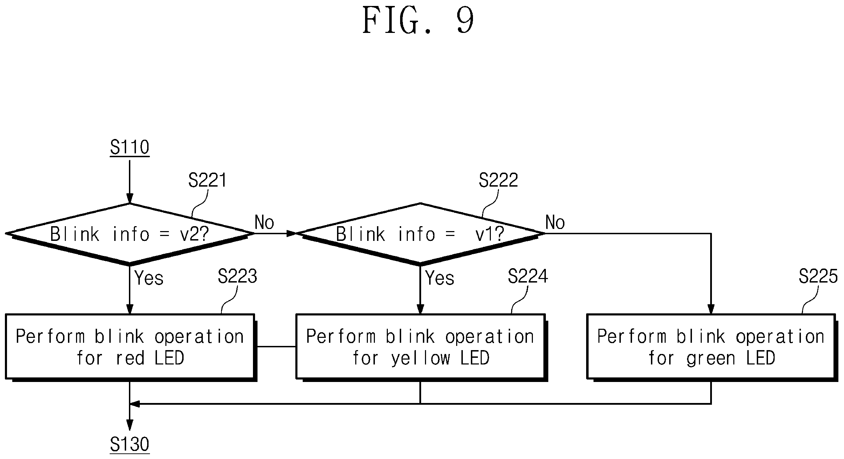

FIG. 9 is a flowchart illustrating operation S120 of FIG. 4 in detail according to example embodiments. Referring to FIGS. 2, 4, 7, and 9, the status display device 140 may perform the blinking operation in response to the blink enable signal. In operation S221, the status display device 140 may determine whether the blink information is the second value V2. For example, the status display device 140 may determine whether the blink information indicates a danger status.

When the blink information is the second value V2 (i.e., when the blink information is determined as the danger status), the status display device 140 may perform operation S223. When the blink information is not the second value V2 (i.e., when the blink information is not determined as the danger status), the status display device 140 may perform operation S222.

In operation S222, the status display device 140 may determine whether the blink information is the first value V1. For example, the status display device 140 may determine whether the blink information indicates a caution status.

When the blink information is the first value V1 (i.e., when the blink information is determined as the caution status), the status display device 140 may perform operation S224. When the blink information is not the first value V1 (i.e., when the blink information is not determined as the caution status), the status display device 140 may perform operation S225.

In operation S223, the status display device 140 may perform the blinking operation on the red light-emitting diode "R". For example, through the blinking operation of the red light-emitting diode "R", the status display device 140 may notify the user that the input voltage Vin exceeding the second reference voltage Vref2 is being received. For example, the status display device 140 may display a danger status to the user.

In operation S224, the status display device 140 may perform the blinking operation on the yellow light-emitting diode "Y". For example, through the blinking operation of the yellow light-emitting diode "Y", the status display device 140 may notify the user that the input voltage Vin exceeding the first reference voltage Vref1 and smaller than or equal to the second reference voltage Vref2 is being received. For example, the status display device 140 may display a caution status to the user.

In operation S225, the status display device 140 may perform the blinking operation on the green light-emitting diode "G". For example, through the blinking operation of the green light-emitting diode "G", the status display device 140 may notify the user that the input voltage Vin smaller than or equal to the first reference voltage Vref1 is being received. For example, the status display device 140 may display a normal status to the user. After operation S223, operation S224, and operation S225, operation S130 may be performed.

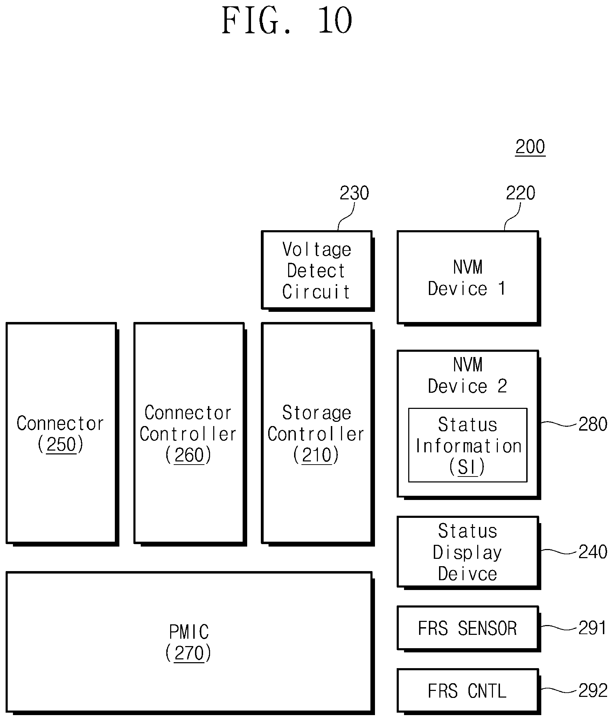

FIG. 10 is a block diagram illustrating a storage device of FIG. 1 according to example embodiments. Referring to FIGS. 1 and 10, a storage device 200 may include a storage controller 210, a first nonvolatile memory device 220, a voltage detect circuit 230, a status display device 240, a connector 250, a connector controller 260, a power management integrated circuit 270, a second nonvolatile memory device 280, a fingerprint recognition sensor 291, and a fingerprint recognition controller 292. For convenience of description, additional description associated with the components described above will be omitted to avoid redundancy.

The fingerprint recognition sensor 291 may be implemented to recognize a fingerprint of a user. In an embodiment, the recognized fingerprint may be stored in an internal memory (i.e., the first nonvolatile memory device 220 or the second nonvolatile memory device 280) of the storage device 200 for user enrollment. A fingerprint stored in a memory may be data that are generated by encrypting or encoding (e.g., hash coding) the recognized fingerprint depending on a manner determined in advance. In an embodiment, the recognized fingerprint may be compared with the fingerprint stored in the internal memory of the storage device 200 for user authentication.

The fingerprint recognition sensor 291 may be implemented to sense an electrical characteristic difference according to ridge and valley shapes of a fingerprint. For example, the fingerprint recognition sensor 291 may be implemented to sense a capacitance difference corresponding to a fingerprint, that is, a capacitance signal and to convert the sensed capacitance signal into an electrical signal.

The fingerprint recognition controller 292 may be implemented to control overall operations of the fingerprint recognition sensor 291. In an embodiment, the fingerprint recognition controller 292 may determine whether to enable the fingerprint recognition sensor 291. For example, the fingerprint recognition controller 292 may enable the fingerprint recognition sensor 291 based on an operating mode of the storage device 200. The fingerprint recognition controller 292 may receive information about the operating mode of the storage device 200 from the storage controller 210. For example, when the operating mode is a security mode, the fingerprint recognition controller 292 may enable the fingerprint recognition sensor 291.

Also, the fingerprint recognition controller 292 may convert a received fingerprint in the form of data that is able to be enrolled at the internal memory of the storage device 200. In an embodiment, the fingerprint recognition controller 292 may receive the recognized fingerprint from the fingerprint recognition sensor 291, may convert (code) the received fingerprint based on an algorithm determined in advance, and may provide the converted fingerprint to the storage controller 210 for fingerprint enrollment of the user. In an embodiment, with regard to enrolling and authenticating a user fingerprint, the fingerprint recognition controller 292 may provide the storage controller 210 with data write and read requests.

Also, for fingerprint authentication, the fingerprint recognition controller 292 may compare a fingerprint recognized by the fingerprint recognition sensor 291 with a fingerprint enrolled at the internal memory of the storage device 200. For example, the fingerprint recognition controller 292 may determine whether a user is legal, by receiving a sensed fingerprint from the fingerprint recognition sensor 291, reading an enrolled fingerprint of the user from the first nonvolatile memory device 220, and comparing the received fingerprint and the read fingerprint.

In an embodiment, the fingerprint recognition controller 292 and the storage controller 210 may communicate with each other through at least one of I²C, system management bus (SMBus), universal asynchronous receiver transmitter (UART), serial peripheral interface (SPI), and high-speed inter-chip (HSIC).

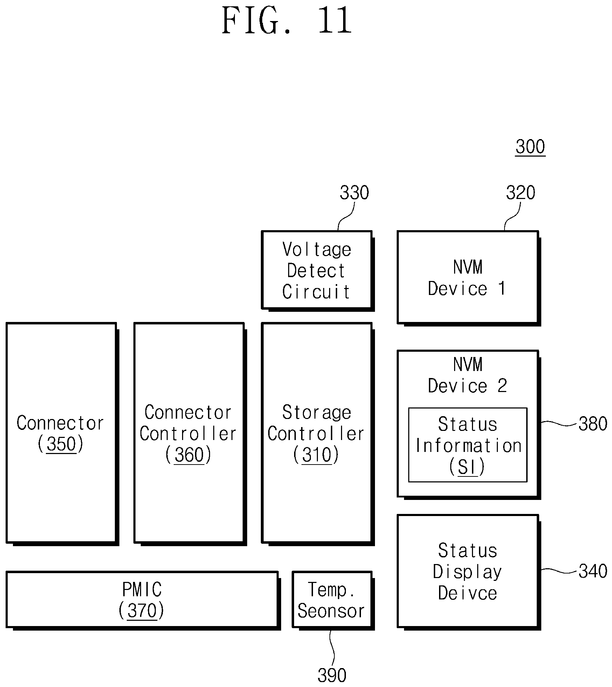

FIG. 11 is a block diagram illustrating a storage device of FIG. 1 according to example embodiments. Referring to FIGS. 1 and 11, a storage device 300 may include a storage controller 310, a first nonvolatile memory device 320, a voltage detect circuit 330, a status display device 340, a connector 350, a connector controller 360, a power management integrated circuit 370, a second nonvolatile memory device 380, and a temperature sensor 390. For convenience of description, additional description associated with the components described above will be omitted to avoid redundancy.

The temperature sensor 390 may detect a temperature of the storage device 300 and may provide second status information about the detected temperature to the storage controller 310. For example, the temperature sensor 390 may send the second status information to the storage controller 310 depending on a request.

In an embodiment, the storage controller 310 may request the second status information from the temperature sensor 390. The storage controller 310 may receive the second status information from the temperature sensor 390. The storage controller 310 may write the second status information provided by the temperature sensor 390 in the second nonvolatile memory device 380.

The storage controller 310 may write the status information SI including the second status information in the second nonvolatile memory device 380. The second status information stored in the second nonvolatile memory device 380 may be used for fault analysis. The storage controller 310 may update a log with the status information SI including the second status information. The storage controller 310 may provide the status information SI including the second status information to the host 11 depending on a request from the host 11.

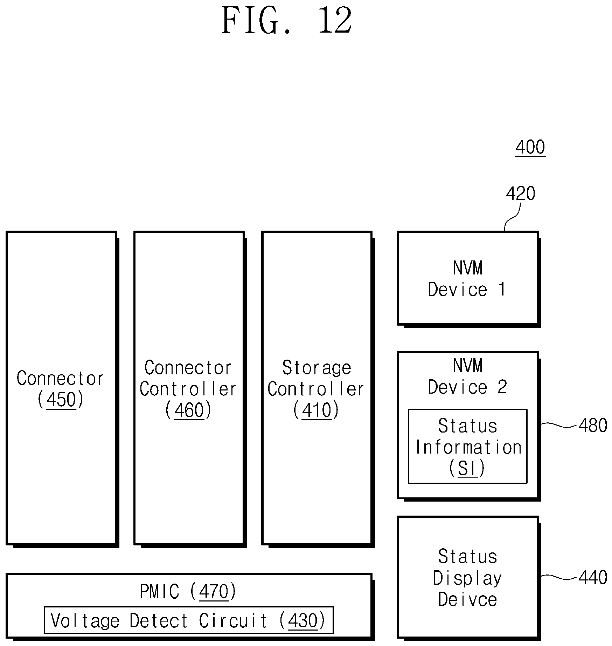

FIG. 12 is a block diagram illustrating a storage device of FIG. 1 according to example embodiments. Referring to FIGS. 1 and 12, a storage device 400 may include a storage controller 410, a first nonvolatile memory device 420, a status display device 440, a connector 450, a connector controller 460, a power management integrated circuit 470, and a second nonvolatile memory device 480. For convenience of description, additional description associated with the components described above will be omitted to avoid redundancy.

The power management integrated circuit 470 may include a voltage detect circuit 430. In the embodiment of FIG. 2, the power management integrated circuit 170 and the voltage detect circuit 130 may be implemented with different chips. In contrast, in the embodiment of FIG. 12, the power management integrated circuit 470 and the voltage detect circuit 430 may be implemented with one chip.

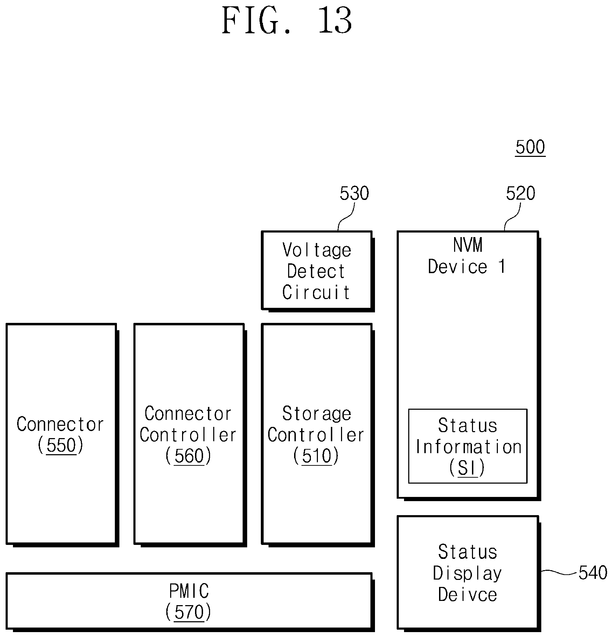

FIG. 13 is a block diagram illustrating a storage device of FIG. 1 according to example embodiments. Referring to FIGS. 1 and 13, a storage device 500 may include a storage controller 510, a first nonvolatile memory device 520, a voltage detect circuit 530, a status display device 540, a connector 550, a connector controller 560, and a power management integrated circuit 570. For convenience of description, additional description associated with the components described above will be omitted to avoid redundancy.

The storage device 100 of FIG. 2 may include the second nonvolatile memory device 180. In contrast, the storage device 500 of FIG. 13 may not include a second nonvolatile memory device. The storage device 500 of FIG. 13 may include the status information SI in the first nonvolatile memory device 520 storing user data.

For example, the storage controller 510 may receive first status information from the power management integrated circuit 570. The storage controller 510 may write the status information SI including the first status information in the first nonvolatile memory device 520.

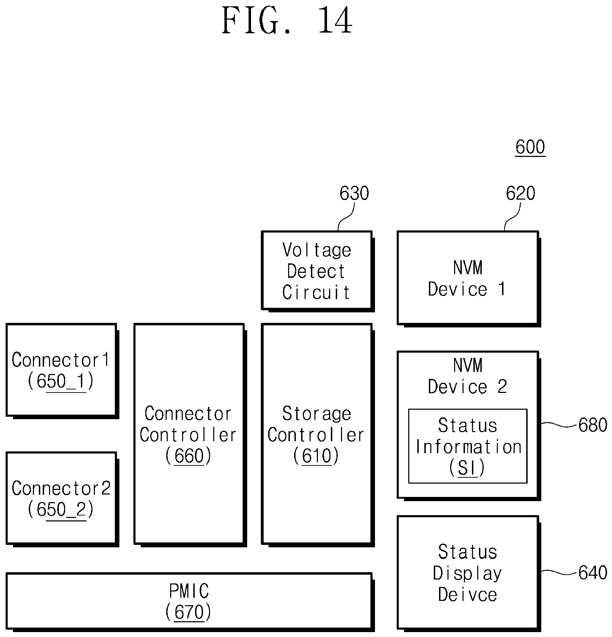

FIG. 14 is a block diagram illustrating a storage device of FIG. 1 according to example embodiments. Referring to FIGS. 1 and 14, a storage device 600 may include a storage controller 610, a first nonvolatile memory device 620, a voltage detect circuit 630, a status display device 640, a first connector 650_1, a second connector 650_2, a connector controller 660, a power management integrated circuit 670, and a second nonvolatile memory device 680. For convenience of description, additional description associated with the components described above will be omitted to avoid redundancy.

The connector controller 160 of FIG. 2 may communicate with the host 11 through a first interface and may communicate with the storage controller 110 through a second interface. In contrast, the connector controller 660 of FIG. 14 may communicate with the host 11 through the first interface and a third interface and may communicate with the storage controller 610 through the second interface.

In an embodiment, the first connector 650_1 may be a port corresponding to the first interface. For example, the first connector 650_1 may be a USB port. The second connector 650_2 may be a port corresponding to the third interface. For example, the second connector 650_2 may be a thunderbolt port.

In an embodiment, the connector controller 660 may transmit/receive a first interface-based signal through the first connector 650_1. The connector controller 660 may convert a first interface-based signal into a second interface-based signal so as to be output to the storage controller 610. The connector controller 660 may receive the second interface-based signal from the storage controller 610 and may convert the second interface-based signal into the first interface-based signal.

In an embodiment, the connector controller 660 may transmit/receive a third interface-based signal through the second connector 650_2. The connector controller 660 may convert the third interface-based signal into the second interface-based signal so as to be output to the storage controller 610. The connector controller 660 may receive the second interface-based signal from the storage controller 610 and may convert the second interface-based signal into the third interface-based signal. As described above, the storage device 600 may communicate with the host 11 through a plurality of interfaces. For example, the storage device 600 may communicate with the host 11 through the USB interface and the thunderbolt interface.

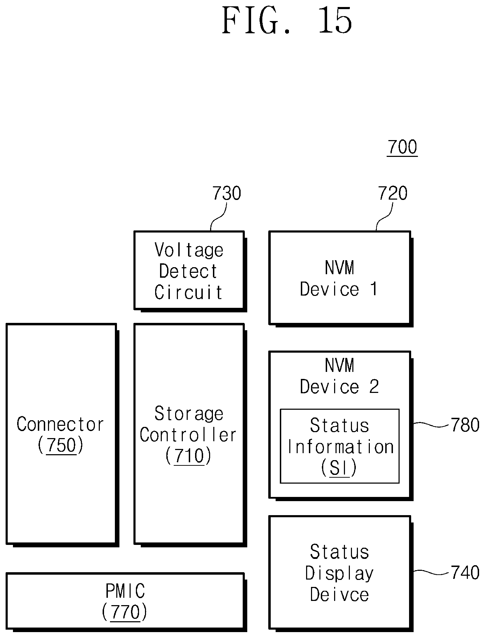

FIG. 15 is a block diagram illustrating a storage device of FIG. 1 according to example embodiments. Referring to FIGS. 1 and 15, a storage device 700 may include a storage controller 710, a first nonvolatile memory device 720, a voltage detect circuit 730, a status display device 740, a connector 750, a power management integrated circuit 770, and a second nonvolatile memory device 780. For convenience of description, additional description associated with the components described above will be omitted to avoid redundancy.

The storage device 100 of FIG. 2 may include the connector controller 160. The storage device 100 of FIG. 2 may be a portable storage device that communicates with the host 11 through a first interface. In contrast, the storage device 700 of FIG. 15 may be a storage device that communicates with the host 11 through a second interface. For example, the storage device 700 may not include the connector controller 160.

In an embodiment, the connector 750 of FIG. 15 may be a port corresponding to the second interface. For example, the connector 750 may be a PCIe port. The storage device 700 of FIG. 15 may communicate with the host 11 in compliance with a PCIe interface standard. The storage controller 710 may transmit/receive a signal according to the PCIe interface standard to/from the connector 750.

As described above, when an input voltage exceeds a reference voltage, a storage device may detect whether an over-voltage is received. When it is determined that the over-voltage is received, the storage device may provide a notification to a user through a status display device. As such, the user may check a connection status of the storage device and a host and may perform a work such as disconnection of the storage device from the host. For fault analysis, the storage device may store status information of the storage device in a second nonvolatile memory device. The storage device may provide notification that an over-voltage is received, through an asynchronous event request completion, and may provide status information to the host.

According to an embodiment of the present disclosure, there are provided a storage system, a storage device, and an operation method of the storage device, which are capable of displaying an over-voltage input status to a user through a status display device and providing the over-voltage input status and status information to a host when an over-voltage is received from a host through a connector.

While the present disclosure has been described with reference to embodiments thereof, it will be apparent to those of ordinary skill in the art that various changes and modifications may be made thereto without departing from the scope of the invention as set forth in the following claims.

## Claims

1. A storage device comprising:
a first nonvolatile memory device (120) configured to store user data;
a second nonvolatile memory device (180) configured to store status information for fault analysis;
a voltage detect circuit (130) configured to:
detect whether an input voltage received at the storage device (100) through a connector (150) exceeds a reference voltage, and
output an over-voltage detect signal when the input voltage exceeds the reference voltage,
a status display device (140) configured to display a status of the input voltage in response to an alert signal; and
a storage controller (110) configured to:
store or read the user data in or from the first nonvolatile memory device,
output the alert signal to the status display device (140) in response to the over-voltage detect signal, and
store the status information in the second nonvolatile memory device (180).

2. The storage device of claim 1, wherein the status display device (140) includes a light-emitting diode and is configured to perform a blinking operation on the light-emitting diode in response to the alert signal.

3. The storage device of claim 1 or 2, further comprising:
a power management integrated circuit (170) configured to supply a power to the first nonvolatile memory device (120), the second nonvolatile memory device (180), and the storage controller (110) and to provide first status information in response to a request from the storage controller (110),
wherein the status information includes the first status information of the power management integrated circuit (170).

4. The storage device of claim 3, wherein the first status information includes one of information about an internal voltage of the power management integrated circuit (170), information about a current of the power management integrated circuit (170), information about an operating voltage used in an operation of the first nonvolatile memory device (120), information about a status signal (PWR_GOOD), and information about an operating mode of the power management integrated circuit (170).

5. The storage device of any one of claims 1 to 4, further comprising:
a temperature sensor (390) configured to detect a temperature of the storage device (300) and to provide second status information including temperature information in response to a request from the storage controller (310),
wherein the status information includes the second status information of the temperature sensor (390).

6. The storage device of any one of claims 1 to 5, further comprising:
a connector (150) connected to an external host (11) through a universal serial bus (USB) interface or a thunderbolt interface; and
a connector controller (160) connected to the connector and configured to communicate with the storage controller through a peripheral component interconnect express (PCIe) interface.

7. The storage device of any one of claims 1 to 6, wherein the storage controller (110) is configured to write the status information additionally in the first nonvolatile memory device (120).

8. The storage device of any one of claims 1 to 7, wherein the storage controller (110) is configured to notify the status of the input voltage to an external host through an asynchronous event request completion.

9. The storage device of any one of claims 1 to 8, further comprising:
a fingerprint recognition sensor (291) configured to recognize a fingerprint of a user; and
a fingerprint recognition controller (292) configured to:
control the fingerprint recognition sensor (291),
enroll the fingerprint of the user, and
compare the recognized fingerprint and the enrolled fingerprint.

10. The storage device of any one of claims 1 to 9, wherein the second nonvolatile memory (180) device includes at least one of a read only memory (ROM), a programmable ROM (PROM), an electrically programmable ROM (EPROM), an electronic fuse (eFuse), an electrically erasable and programmable ROM (EEPROM), a mask ROM, a serial PROM, a flash memory, a one-time programmable (OTP) memory, and a serial flash memory.

11. An operation method of a storage device according to any one previous claim, the method comprising:
detecting by the voltage detect circuit (130) whether an over-voltage greater than a first reference voltage is received at the storage device (100) through a connector (150);
outputting by the voltage detect circuit (130) an over-voltage detect signal when the input voltage exceeds the reference voltage;
storing, by the storage controller (110), status information in the second nonvolatile memory device (180);
outputting, by the storage controller, an alert signal to the status display device (140) in response to the over-voltage detect signal; and
displaying, by the status display device (140), an over-voltage input status in response to the alert signal.

12. The method of claim 11, further comprising:
providing the over-voltage input status and the status information to the external host, wherein the status information includes status information of each of integrated circuits included in the storage device for fault analysis.

13. The method of claim 11 or 12, wherein the displaying of the over-voltage input status by the status display device includes:
performing a blinking operation on a light-emitting diode included in the status display device (140) in response to the alert signal.

14. The method of claim 11, 12, or 13, wherein the storing of the status information in the nonvolatile memory device (180) includes, by the storage controller (110):
requesting first status information to a power management integrated circuit (170);
receiving the first status information from the power management integrated circuit (170);
requesting second status information to a temperature sensor (390);
receiving the second status information from the temperature sensor (390); and
writing the status information including the first status information and the second status information in the nonvolatile memory device (180).

## Patentansprüche

1. Speicherungsvorrichtung, umfassend:
eine erste nichtflüchtige Speichervorrichtung (120), die dafür konfiguriert ist, Benutzerdaten zu speichern;
eine zweite nichtflüchtige Speichervorrichtung (180), die dafür konfiguriert ist, Statusinformationen zwecks Fehleranalyse zu speichern;
eine Spannungsermittlungsschaltung (130), die dafür konfiguriert ist:
zu ermitteln, ob eine an der Speicherungsvorrichtung (100) über einen Verbinder (150) empfangene Eingangsspannung eine Referenzspannung überschreitet, und
ein Überspannung-Ermittlungssignal auszugeben, wenn die Eingangsspannung die Referenzspannung überschreitet,
eine Statusanzeigevorrichtung (140), die dafür konfiguriert ist, als Antwort auf ein Warnsignal einen Status der Eingangsspannung anzuzeigen; und
eine Speicher-Steuerungseinrichtung (110), die dafür konfiguriert ist, um:
die Benutzerdaten in oder aus der ersten nichtflüchtigen Speichervorrichtung zu speichern oder zu lesen,
als Antwort auf das Überspannung-Ermittlungssignal das Alarmsignal an die Statusanzeigevorrichtung (140) auszugeben, und
die Statusinformationen in der zweiten nichtflüchtigen Speichervorrichtung (180) zu speichern.

2. Speicherungsvorrichtung nach Anspruch 1, wobei die Statusanzeigevorrichtung (140) eine Leuchtdiode einschließt und dafür konfiguriert ist, als Antwort auf das Alarmsignal einen Blinkbetrieb an der Leuchtdiode durchzuführen.

3. Speicherungsvorrichtung nach Anspruch 1 oder 2, ferner umfassend:
einen integrierten Energieverwaltungsschaltkreis (170), der dafür konfiguriert ist, der ersten nichtflüchtigen Speichervorrichtung (120), der zweiten nichtflüchtigen Speichervorrichtung (180) und der Speicher-Steuerungseinrichtung (110) Energie zuzuführen und als Antwort auf eine Anfrage von der Speicher-Steuerungseinrichtung (110) erste Statusinformationen bereitzustellen,
wobei die Statusinformationen die ersten Statusinformationen des integrierten Energieverwaltungsschaltkreises (170) einschließen.

4. Speicherungsvorrichtung nach Anspruch 3, wobei die ersten Statusinformationen eines von Folgendem einschließen: Informationen über eine interne Spannung des integrierten Energieverwaltungsschaltkreises (170), Informationen über einen Strom des integrierten Energieverwaltungsschaltkreises (170), Informationen über eine Betriebsspannung, die im Betrieb der ersten nichtflüchtigen Speichervorrichtung (120) verwendet wird, Informationen über ein Statussignal (PWR_GOOD) und Informationen über eine Betriebsart des integrierten Energieverwaltungsschaltkreises (170).

5. Speicherungsvorrichtung nach einem der Ansprüche 1 bis 4, ferner umfassend:
einen Temperatursensor (390), der dafür konfiguriert ist, eine Temperatur der Speicherungsvorrichtung (300) zu ermitteln und als Antwort auf eine Anforderung von der Speicher-Steuerungseinrichtung (310) zweite Statusinformationen einschließlich Temperaturinformationen bereitzustellen,
wobei die Statusinformationen die zweiten Statusinformationen des Temperatursensors (390) einschließen.

6. Speicherungsvorrichtung nach einem der Ansprüche 1 bis 5, ferner umfassend:
einen Verbinder (150), der mit einem externen Host (11) über eine Universal Serial Bus (USB-)Schnittstelle oder eine Thunderbolt-Schnittstelle verbunden ist; und
eine Verbinder-Steuerungseinrichtung (160), die mit dem Verbinder verbunden und dafür konfiguriert ist, mit der Speicher-Steuerungseinrichtung über eine Peripheral Component Interconnect Express (PCIe-)Schnittstelle zu kommunizieren.

7. Speicherungsvorrichtung nach einem der Ansprüche 1 bis 6, wobei die Speicher-Steuerungseinrichtung (110) dafür konfiguriert ist, die Statusinformationen zusätzlich in die erste nichtflüchtige Speichervorrichtung (120) zu schreiben.

8. Speicherungsvorrichtung nach einem der Ansprüche 1 bis 7, wobei die Speicher-Steuerungseinrichtung (110) dafür konfiguriert ist, den Status der Eingangsspannung über eine asynchrone Ereignisanforderungsabwicklung an einen externen Host zu melden.

9. Speicherungsvorrichtung nach einem der Ansprüche 1 bis 8, ferner umfassend:
einen Fingerabdruckerkennung-Sensor (291), der dafür konfiguriert ist, einen Fingerabdruck eines Benutzers zu erkennen; und
eine Fingerabdruckerkennung-Steuerungseinrichtung (292), der dafür konfiguriert ist:
den Fingerabdruckerkennung-Sensor (291) zu steuern,
den Fingerabdruck des Benutzers zu registrieren, und
den erkannten Fingerabdruck und den registrierten Fingerabdruck zu vergleichen.

10. Speichervorrichtung nach einem der Ansprüche 1 bis 9, wobei die zweite nichtflüchtige Speichervorrichtung (180) mindestens eines von Folgendem einschließt: ein Festwertspeicher (ROM), ein programmierbarer ROM (PROM), ein elektrisch programmierbarer ROM (EPROM), eine elektronische Sicherung (eFuse), ein elektrisch löschbarer und programmierbarer ROM (EEPROM), ein Masken-ROM, ein serieller PROM, ein Flash-Speicher, ein einmalig programmierbarer (OTP) Speicher und ein serieller Flash-Speicher.

11. Betriebsverfahren einer Speicherungsvorrichtung nach einem der vorhergehenden Ansprüche, wobei das Verfahren umfasst:
Ermitteln durch die Spannungsermittlungsschaltung (130), ob an der Speicherungsvorrichtung (100) eine Überspannung, die größer als eine erste Referenzspannung ist, über einen Verbinder (150) empfangen wird;
Ausgeben eines Überspannung-Ermittlungssignals durch die Spannungsermittlungsschaltung (130), wenn die Eingangsspannung die Referenzspannung überschreitet;
Speichern von Statusinformationen durch die Speicher-Steuerungseinrichtung (110) in der zweiten nichtflüchtigen Speichervorrichtung (180);
Ausgeben eines Warnsignals durch die Speicher-Steuerungseinrichtung an die Statusanzeigevorrichtung (140) als Antwort auf das Überspannung-Ermittlungssignal; und
Anzeigen eines Überspannung-Eingangsstatus durch die Statusanzeigevorrichtung (140) als Antwort auf das Warnsignal.

12. Verfahren nach Anspruch 11, ferner umfassend:
Bereitstellen des Überspannung-Eingangsstatus und der Statusinformationen für den externen Host, wobei die Statusinformationen zwecks Fehleranalyse Statusinformationen von jedem der in die Speicherungsvorrichtung eingeschlossenen integrierten Schaltkreise einschließen.

13. Verfahren nach Anspruch 11 oder 12, wobei das Anzeigen des Überspannung-Eingangsstatus durch die Statusanzeigevorrichtung einschließt:
Durchführen eines Blinkbetriebs an einer Leuchtdiode, die in die Statusanzeigevorrichtung (140) eingeschlossen ist, als Antwort auf das Alarmsignal.

14. Verfahren nach Anspruch 11, 12 oder 13, wobei das Speichern der Statusinformationen in der nichtflüchtigen Speichervorrichtung (180) einschließt: durch die Speicher-Steuerungseinrichtung (110) erfolgendes
Anfordern erster Statusinformationen von einem integrierten Energieverwaltungsschaltkreis (170);
Empfangen der ersten Statusinformationen von dem integrierten Energieverwaltungsschaltkreis (170);
Anfordern zweiter Statusinformationen von einem Temperatursensor (390);
Empfangen der zweiten Statusinformationen von dem Temperatursensor (390); und
Schreiben der Statusinformationen einschließlich der ersten Statusinformationen und der zweiten Statusinformationen in die nichtflüchtige Speichervorrichtung (180).

## Revendications

1. Dispositif de stockage comprenant :
un premier dispositif de mémoire non volatile (120) configuré pour stocker des données d'utilisateur,
un deuxième dispositif de mémoire non volatile (180) configuré pour stocker des informations d'état pour une analyse des défauts,
un circuit de détection de tension (130) configuré pour :
détecter si un signal de tension d'entrée reçu au niveau du dispositif de stockage (100) à travers un connecteur (150) est supérieur à une tension de référence, et
émettre en sortie un signal de détection de surtension lorsque la tension d'entrée est supérieure à la tension de référence,
un dispositif d'affichage d'état (140) configuré pour afficher un état de la tension d'entrée en réponse à un signal d'alerte, et
un dispositif de commande de stockage (110) configuré pour :
stocker ou lire les données d'utilisateur dans ou à partir du premier dispositif de mémoire non volatile,
émettre en sortie le signal d'alerte au dispositif d'affichage d'état (140) en réponse au signal de détection de surtension, et
stocker les informations d'état dans le deuxième dispositif de mémoire non volatile (180).

2. Dispositif de stockage selon la revendication 1, dans lequel le dispositif d'affichage d'état (140) inclut une diode électroluminescente et est configuré pour exécuter une commande de clignotement sur la diode électroluminescente en réponse au signal d'alerte.

3. Dispositif de stockage selon la revendication 1 ou 2, comprenant en outre :
un circuit intégré de gestion d'énergie (170) configuré pour alimenter en énergie le premier dispositif de mémoire non volatile (120), le deuxième dispositif de mémoire non volatile (180) et le dispositif de commande de stockage (110), et pour fournir des premières informations d'état en réponse à une demande du dispositif de commande de stockage (110),
dans lequel les informations d'état incluent les premières informations d'état du circuit intégré de gestion d'énergie (170).

4. Dispositif de stockage selon la revendication 3, dans lequel les premières informations d'état incluent l'une des suivantes : des informations sur une tension interne du circuit intégré de gestion d'énergie (170), des informations sur un courant du circuit intégré de gestion d'énergie (170), des informations sur une tension de service utilisée dans le fonctionnement du premier dispositif de mémoire non volatile (120), des informations sur un signal d'état (PWR_GOOD), et des informations sur un mode de fonctionnement du circuit intégré de gestion d'énergie (170).

5. Dispositif de stockage selon l'une quelconque des revendications 1 à 4, comprenant en outre :
un capteur de température (390) configuré pour détecter une température du dispositif de stockage (300) et pour fournir des deuxièmes informations d'état incluant des informations de température en réponse à une demande du dispositif de commande de stockage (310),
dans lequel les informations d'état incluent les deuxièmes informations d'état du capteur de température (390).

6. Dispositif de stockage selon l'une quelconque des revendications 1 à 5, comprenant en outre :
un connecteur (150) connecté à un hôte externe (11) par le biais d'une interface de bus série universel (USB) ou d'une interface Thunderbolt, et
un dispositif de commande de connecteur (160) connecté au connecteur et configuré pour communiquer avec le dispositif de commande de stockage via une interface d'interconnexion de composants périphériques express (PCI-E).

7. Dispositif de stockage selon l'une quelconque des revendications 1 à 6, dans lequel le dispositif de commande de stockage (110) est configuré pour écrire les informations d'état additionnellement dans le premier dispositif de mémoire non volatile (120).

8. Dispositif de stockage selon l'une quelconque des revendications 1 à 7, dans lequel le dispositif de commande de stockage (110) est configuré pour indiquer l'état de la tension d'entrée à un hôte externe par le biais de la réalisation d'une demande d'évènement asynchrone.

9. Dispositif de stockage selon l'une quelconque des revendications 1 à 8, comprenant en outre :
un capteur de reconnaissance d'empreinte digitale (291) configuré pour reconnaître une empreinte digitale d'un utilisateur, et
un dispositif de commande de reconnaissance d'empreinte digitale (292) configuré pour :
commander le capteur de reconnaissance d'empreinte digitale (291),
enregistrer l'empreinte digitale de l'utilisateur, et
comparer l'empreinte digitale reconnue et l'empreinte digitale enregistrée.

10. Dispositif de stockage selon l'une quelconque des revendications 1 à 9, dans lequel le deuxième dispositif de mémoire non volatile (180) inclut au moins un des suivants : une mémoire morte (ROM), une ROM programmable (PROM), une ROM électriquement programmable (EPROM), un fusible électronique (eFuse), une ROM électriquement effaçable et programmable (EEPROM), une ROM programmée par masque, une PROM série, une mémoire flash, une mémoire programmable une fois (OTP), et une mémoire flash série.

11. Procédé d'exploitation d'un dispositif de stockage selon l'une quelconque des revendications précédentes, le procédé comprenant les étapes consistant à :
détecter, par le biais du circuit de détection de tension (130), si une surtension supérieure à une première tension de référence est reçue au niveau du dispositif de stockage (100) par le biais d'un connecteur (150),
émettre en sortie, par le biais du circuit de détection de tension (130), un signal de détection de surtension lorsque la tension d'entrée est supérieure à la tension de référence,
stocker, par le biais du dispositif de commande de stockage (110), des informations d'état dans le deuxième dispositif de mémoire non volatile (180),
émettre en sortie, par le biais du dispositif de commande de stockage, un signal d'alerte au dispositif d'affichage d'état (140) en réponse au signal de détection de surtension, et
afficher, par le biais du dispositif d'affichage d'état (140), un état d'entrée de surtension en réponse au signal d'alerte.

12. Procédé selon la revendication 11, comprenant en outre :
la fourniture de l'état d'entrée de surtension et des informations d'état à l'hôte externe, dans lequel les informations d'état incluent des informations d'état de chacun des circuits intégrés inclus dans le dispositif de stockage pour une analyse des défauts.

13. Procédé selon la revendication 11 ou 12, dans lequel l'affichage de l'état d'entrée de surtension par le dispositif d'affichage d'état inclut :
l'exécution d'une commande de clignotement sur une diode électroluminescente incluse dans le dispositif d'affichage d'état (140) en réponse au signal d'alerte.

14. Procédé selon la revendication 11, 12 ou 13, dans lequel le stockage des informations d'état dans le dispositif de mémoire non volatile (180) inclut, par le dispositif de commande de stockage (110) :
la demande de premières informations d'état à un circuit intégré de gestion d'énergie (170),
la réception des premières informations d'état de la part du circuit intégré de gestion d'énergie (170),
la demande de deuxièmes informations d'état à un capteur de température (390),
la réception des deuxièmes informations d'état du capteur de température (390), et
l'écriture des informations d'état, incluant les premières informations d'état et les deuxièmes informations d'état, dans le dispositif de mémoire non volatile (180).
